# EUROPEAN PATENT APPLICATION

(11) **EP 4 068 627 A1**
(43) Date of publication of application: **05.10.2022**
(21) Application number: 20879141.8
(22) Date of filing: 06.05.2020
(51) Int. Cl.: H03H 9/02

(54) **BULK ACOUSTIC WAVE RESONATOR HAVING ELECTRODE HAVING GAP LAYER, AND FILTER AND ELECTRONIC DEVICE**

(30) Priority: 23.10.2019 CN 201911009262
(71) Applicant: Rofs Microsystem (Tianjin) Co., Ltd, Tianjin 300462 (CN)
(72) Inventor: PANG, Wei, Tianjin 300072 (CN); XU, Yang, Tianjin 300462 (CN); HAO, Long, Tianjin 300072 (CN); ZHANG, Menglun, Tianjin 300072 (CN); YANG, Qingrui, Tianjin 300072 (CN)
(74) Representative: Meyer-Dulheuer MD Legal Patentanwälte PartG mbB
(86) International application number: PCT/CN2020/088660
(87) International publication number: WO 2021/077711

(57) **Abstract**

The present disclosure relates to a bulk acoustic wave resonator, including: a substrate; an acoustic mirror; a bottom electrode; a top electrode; and a piezoelectric layer, arranged between the bottom electrode and the top electrode; the bottom electrode and/or the top electrode are gap electrodes, the gap electrode has at least one gap layer, and in the direction of the thickness of the gap electrode, there is a distance between the gap layer and the top and bottom surfaces of the gap electrode. The gap electrode has a plurality of electrode layers arranged stacked in the direction of the thickness of the resonator and connected to each other in parallel, and the gap layer is arranged between the corresponding electrode layers. The present disclosure also relates to a filter having the described resonator and an electronic device having the filter or resonator.

## Description

### TECHNICAL FIELD

Embodiments of the present disclosure relate to the field of semiconductors, and in particular, to a bulk acoustic wave resonator, a filter having the resonator, and an electronic device having the resonator or the filter.

### BACKGROUND

Electronic components have been widely used as basic elements of electronic devices, applications of which include mobile phones, vehicles, household appliances and etc. In addition, technologies such as artificial intelligence, Internet of Things and 5G communications that will change the world in the future still need to rely on the electronic components.

The electronic components can exert different characteristics and advantages according to different working principles. Among all electronic components, components that use a piezoelectric effect (or an inverse piezoelectric effect) for working are an important type of electronic components. Piezoelectric devices have very wide applications. A film bulk acoustic resonator (FBAR, also referred to as Bulk Acoustic Wave Resonator, BAW), as an important member of the piezoelectric devices, is important in the field of communications. In particular, FBAR filters have an increasing market in the field of radio frequency (RF) filters. The FBAR has excellent characteristics such as small size, high resonant frequency, high quality factor, large power capacity, and good roll-off effect. The filters of FBAR are gradually replacing traditional surface acoustic wave (SAW) filters and ceramic filters. The filters of FBAR play a huge role in the field of wireless communication radio frequency, and the high sensitivity advantage thereof can be applied to biological, physical, medical and other sensing fields.

The structural main body of the film bulk acoustic wave resonator is a "sandwich" structure composed of electrode-piezoelectric film-electrode, that is, a piezoelectric material is sandwiched between two metal electrode layers. By inputting a sinusoidal signal between the two electrodes, the FBAR converts the input electrical signal into mechanical resonance by the inverse piezoelectric effect, and converts the mechanical resonance into an electrical signal for output by the piezoelectric effect.

The rapid development of communication technologies requires a continuous increase in the working frequency of a filter. For example, the frequency of a 5G communication frequency band (sub-6G) is between 3 GHz and 6 GHz, which is higher than that of 4G and other communication technologies. As for the bulk acoustic wave resonator and the filter, the high working frequency means that the film thickness, especially the film thickness of an electrode, needs to be further reduced. However, a main negative effect caused by the decrease in the film thickness of the electrode is a decrease in a Q value of the resonator resulting from an increase in the electrical loss, especially a decrease in the Q value at a series resonance point and its nearby frequencies. Correspondingly, the performance of a bulk acoustic wave filter with a high working frequency is greatly deteriorated with the decrease in the Q value of the bulk acoustic wave resonator.

### SUMMARY

The present disclosure is provided to alleviate or solve the above problems in the related art.

According to one aspect of embodiments of the present disclosure, a bulk acoustic wave resonator is provided and includes a substrate, an acoustic lens, a bottom electrode, a top electrode, and a piezoelectric layer provided between the bottom electrode and the top electrode. The bottom electrode and/or the top electrode is a gap electrode, the gap electrode has at least one gap layer. The at least one gap layer is spaced apart from a top surface and a bottom surface of the gap electrode in a thickness direction of the gap electrode.

Optionally, the gap electrode has a plurality of electrode layers that is stacked on each other in the thickness direction of the resonator and connected in parallel to each other, and the at least one gap layer is provided between corresponding ones of the plurality of electrode layers.

The embodiments of the present disclosure also relate to a filter including the above bulk acoustic wave resonator.

The embodiments of the present disclosure also relate to an electronic device including the above filter or the above resonator.

### BRIEF DESCRIPTION OF DRAWINGS

The following description and drawings can help understand these and other features and advantages in various embodiments of the present disclosure. The same reference signs in the drawings always indicate the same components.
Fig. 1 is a schematic top view of a bulk acoustic wave resonator according to an exemplary embodiment of the present disclosure.
Fig. 2A is a schematic sectional view along A1-A2 in Fig. 1 according to an exemplary embodiment of the present disclosure, in which a top electrode is provided with a gap layer.
Fig. 2B is a schematic sectional view along A1-A2 in Fig. 1 according to another exemplary embodiment of the present disclosure, in which a top electrode is provided with a gap layer.
Fig. 2C is a schematic sectional view along A1-A2 in Fig. 1 according to yet another exemplary embodiment of the present disclosure, in which a top electrode is provided with a gap layer.
Fig. 2D is a schematic sectional view along A1-A2 in Fig. 1 according to still another exemplary embodiment of the present disclosure, in which a top electrode is provided with a gap layer.
Fig. 2E is a schematic sectional view along A1-A2 in Fig. 1 according to still another exemplary embodiment of the present disclosure, in which a top electrode is provided with a gap layer.
Fig. 3A is a schematic sectional view along A1-A2 in Fig. 1 according to an exemplary embodiment of the present disclosure, in which a bottom electrode is provided with a gap layer.
Fig. 3B is a schematic sectional view along A1-A2 in Fig. 1 according to another exemplary embodiment of the present disclosure, in which a bottom electrode is provided with a gap layer.
Fig. 4 is a schematic sectional view along A1-A2 in Fig. 1 according to an exemplary embodiment of the present disclosure, in which a top electrode and a bottom electrode are both provided with gap layers.
Fig. 5 is a schematic sectional view along A1-A2 in Fig. 1 according to an exemplary embodiment of the present disclosure, in which a bottom electrode is provided with a gap layer and the gap layer is used as an acoustic lens structure.
Fig. 6 is a frequency-impedance curve graph of a bulk acoustic wave resonator, in which a solid line corresponds to the bulk acoustic wave resonator in Fig. 2A, and a dashed line corresponds to the bulk acoustic wave resonator without a gap layer in an electrode.

### DESCRIPTION OF EMBODIMENTS

The technical solutions of the present disclosure will be further described in detail below through embodiments and in conjunction with the drawings. In the specification, the same or similar reference signs refer to the same or similar components. The following description of the embodiments of the present disclosure with reference to the drawings is intended to explain the general inventive concept of the present disclosure, and should not be construed as a limitation to the present disclosure.

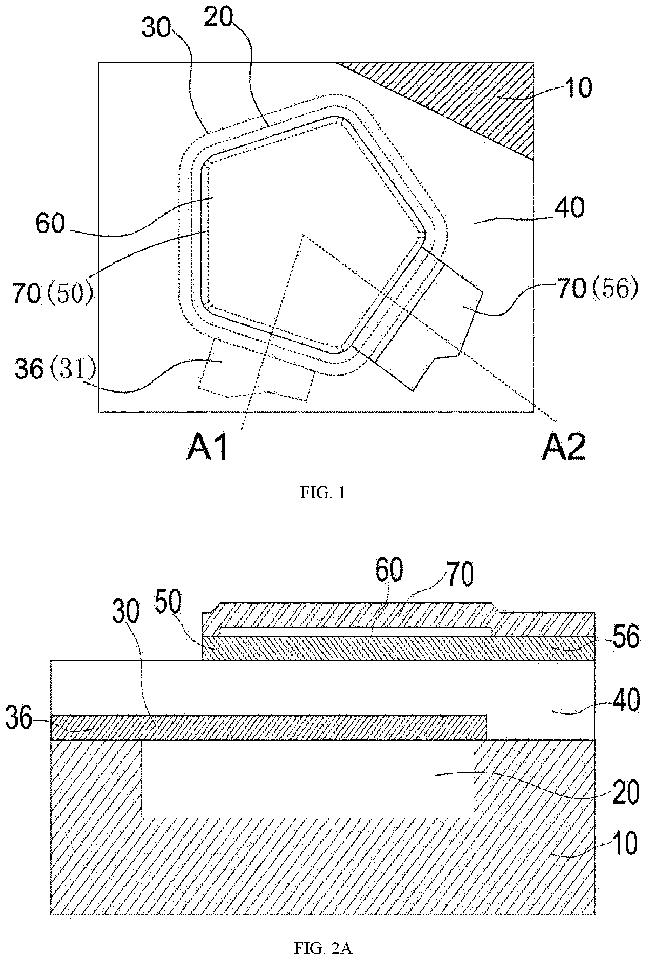

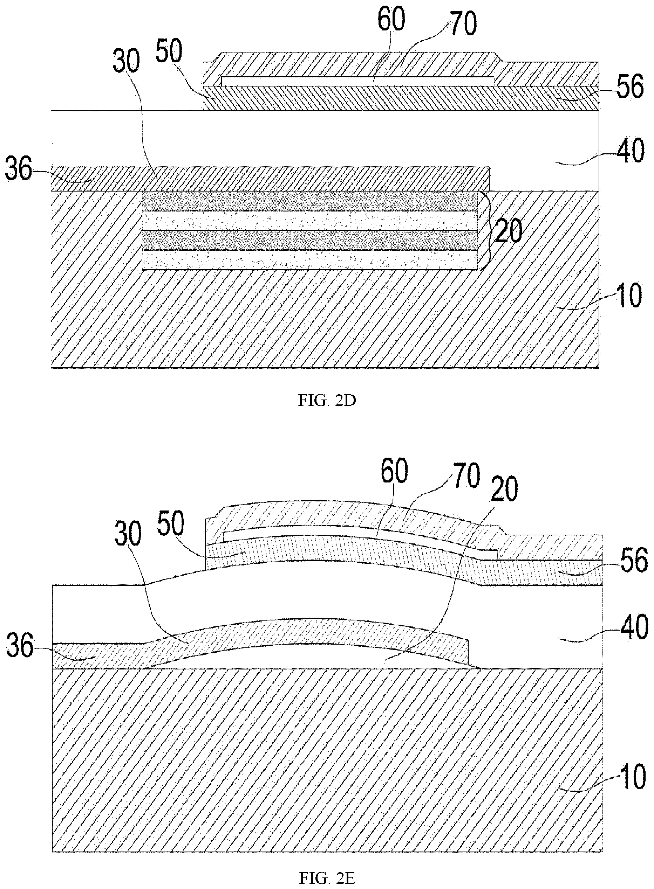

Fig. 1 is a schematic top view of a bulk acoustic wave resonator according to an exemplary embodiment of the present disclosure. In Fig. 1, the reference signs are described as follows:
10: a substrate, which is made of silicon (high-resistance silicon), gallium arsenide, sapphire, quartz or the like;
20: an acoustic lens, which is a cavity 20 in Figs. 2A-2C, or may employ a Bragg reflection layer (e.g., referring to Fig. 2D) or other equivalent forms;
30: a first bottom electrode, which may be made of molybdenum, ruthenium, gold, aluminum, magnesium, tungsten, copper, titanium, iridium, osmium or chromium, or a compound or an alloy thereof;
36: an electrode pin, a material of which is the same as that of the first bottom electrode;
31: a second bottom electrode, a material of which is selected from the same material range as that of the first bottom electrode 30, but the material may not be the same as that of the first bottom electrode 30;
40: a piezoelectric film layer, which may be made of aluminum nitride (AlN), zinc oxide (ZnO), lead zirconate titanate (PZT), lithium niobate (LiNbO₃), quartz, potassium niobate (KNbO₃), lithium tantalate (LiTaO₃) or the like, and may contain rare earth element doped materials with a certain atomic ratio of the above materials;
50: a first top electrode, which may be made of molybdenum, ruthenium, gold, aluminum, magnesium, tungsten, copper, titanium, iridium, osmium or chromium, or a compound or an alloy thereof;
56: an electrode pin, a material of which is the same as that of the first top electrode;
60: an air gap formed in the top electrode and arranged between the first top electrode 50 and a second top electrode 70; and
70: the second top electrode, a material of which is selected from the same material range as that of the first top electrode 50, but the material may not be the same as that of the first top electrode 50.

It should be noted that the air gap forms a gap layer. However, in the present disclosure, the gap layer may be a vacuum gap layer except for an air gap layer, or may be a gap layer filled with other gas medium.

Fig. 2A is a schematic sectional view along A1-A2 in Fig. 1 according to an exemplary embodiment of the present disclosure, in which a top electrode is provided with a gap layer.

As shown in Fig. 2A, the resonator has two layers of top electrodes 50 and 70 (i.e., the first top electrode 50 and the second top electrode 70). The top electrode 70 covers an entire upper surface of the top electrode 50 while the top electrode 70 is kept in contact with the upper surface of the top electrode 50 on a non-electrode pin side and a pin side, thereby forming an air gap 60 between the top electrodes 70 and 50.

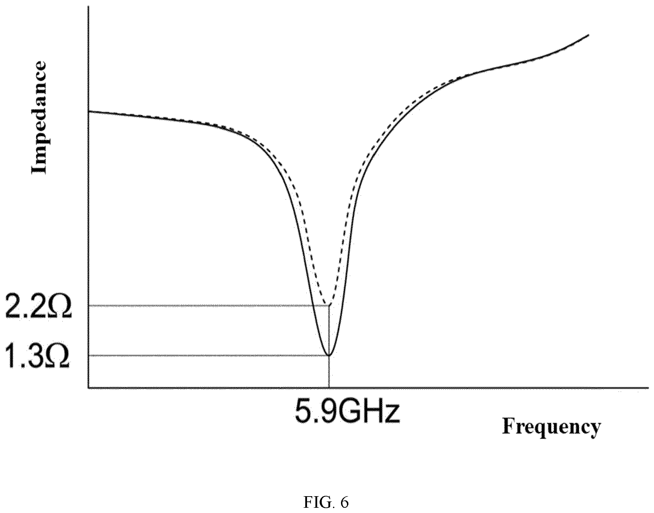

When the resonator is in operation, an alternating electric field is applied to the piezoelectric layer 40 through the electrodes. Due to the coupling and mutual conversion of acoustic and electrical energy, current flows through the electrodes. Since the top electrode of the present embodiment has a double-layer electrode parallel structure, the electrical loss of the resonator is effectively reduced. Under the excitation of the alternating electric field, the piezoelectric layer generates acoustic waves. When the acoustic waves are conducted upwardly to an interface between the air gap 60 in the top electrode and the electrode layer 50, the energy of the acoustic waves will be reflected back to the piezoelectric layer 40 due to a great acoustic impedance mismatching degree between the air and the electrodes, and will not enter the electrode layer 70. On one hand, the electrode structure containing the air gap in the present disclosure significantly reduces the electrical loss of the resonator, i.e. increases a Q value at and near a series resonant frequency, as shown in Fig. 6. When the resonator uses the structure as shown in Fig. 2A in which the electrode contains the air gap, the impedance at a series resonant frequency point of 5.9 GHz and its adjacent region decreases from 2.2 Ohms to 1.3 Ohms. On the other hand, the air gap provides an acoustic isolation function on the top electrode 70, thereby substantially avoiding negative effects, such as changes in the resonant frequency and an electromechanical coupling coefficient, of the electrode layer 70 on the performance of the resonator.

The air gap has a height generally greater than a typical amplitude of the resonator (about 10 nm). For example, the height of the air gap is in a range of 100 Å to 5000 Å. In this way, this is beneficial for decoupling the top electrode 70 from the acoustic energy of a resonator cavity when the resonator works at a high power. In the present embodiment, the resonator cavity is a composite structure formed by the top electrode 50, the piezoelectric layer 40, and the bottom electrode 30.

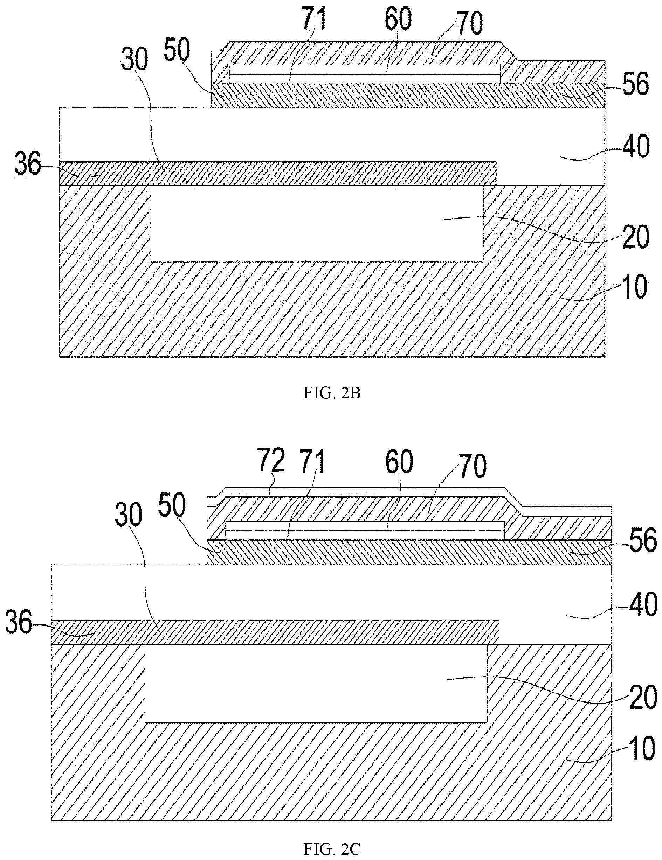

Fig. 2B is a schematic sectional view along A1-A2 in Fig. 1 according to another exemplary embodiment of the present disclosure, in which a top electrode is provided with a gap layer. As shown in Fig. 2B, an upper surface of the top electrode 50 within the coverage region of the air gap 60 is covered with a passivation layer 71, which can prevent the upper surface of the top electrode 50 from being oxidized by elements in the air gap such as oxygen.

Fig. 2C is a schematic sectional view along A1-A2 in Fig. 1 according to yet another exemplary embodiment of the present disclosure, in which a top electrode is provided with a gap layer. In the structure of the bulk acoustic wave resonator shown in Fig. 2C, a part of the upper surface of the top electrode 50 is covered with the passivation layer 71, and the upper surface of the top electrode 70 is also covered with the passivation layer 71, which provides a more comprehensive protection for the top electrode.

Fig. 2D is a schematic sectional view along A1-A2 in Fig. 1 according to still another exemplary embodiment of the present disclosure, in which a top electrode is provided with a gap layer. In the structure of the bulk acoustic wave resonator shown in Fig. 2D, the acoustic lens 20 employs a Bragg reflection layer formed by alternately stacking high and low acoustic resistance layers, instead of the air cavity shown in Fig. 2A.

Fig. 2E is a schematic sectional view along A1-A2 in Fig. 1 according to still another exemplary embodiment of the present disclosure, in which a top electrode is provided with a gap layer. In the structure of the bulk acoustic wave resonator shown in Fig. 2E, an acoustic lens cavity 20 is formed between a lower surface of the lower electrode 30 and the upper surface of the substrate 10, instead of the air cavity formed inside the substrate as shown in Fig. 2A. The air cavity 20 has an arc-shaped upper surface arching upwardly, such that an air gap 70 is formed between a first upper electrode 50 with a bent shape and a second upper electrode 70.

In the embodiments shown in Figs. 2A-2E, the top electrode 70 corresponds to an additional electrode or additional electrode layer.

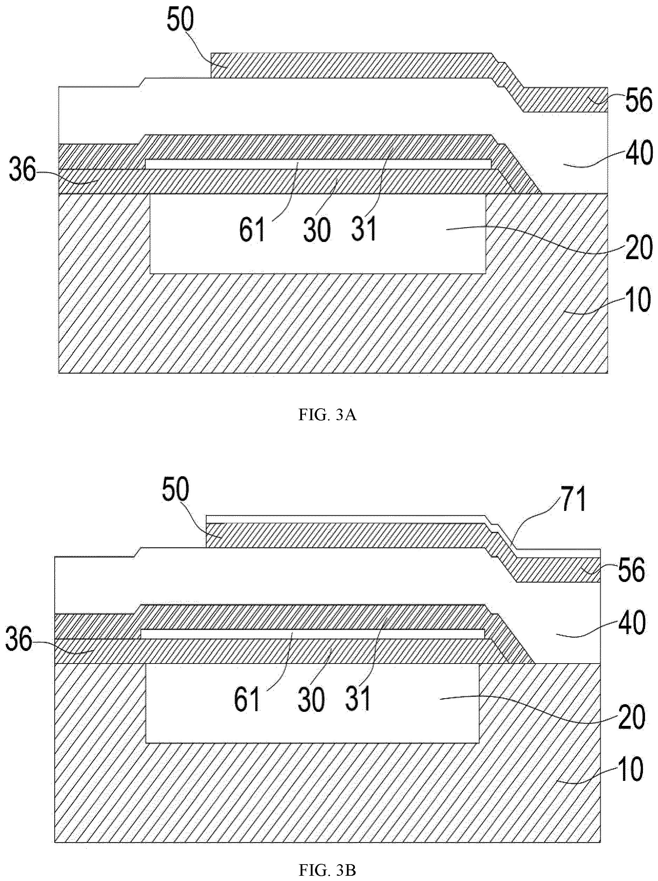

Fig. 3A is a schematic sectional view along A1-A2 in Fig. 1 according to an exemplary embodiment of the present disclosure, in which a bottom electrode is provided with a gap layer. As shown in Fig. 3A, an air gap 61 is formed between a bottom electrode 30 and a bottom electrode 31.

Fig. 3B is a schematic sectional view along A1-A2 in Fig. 1 according to another exemplary embodiment of the present disclosure, in which a bottom electrode is provided with a gap layer. As shown in Fig. 3B, an upper surface of a top electrode 50 is covered with a passivation layer 71 to prevent the top electrode 50 from being oxidized by air.

In the embodiments shown in Figs. 3A-3B, the bottom electrode 30 is an additional electrode or additional electrode layer.

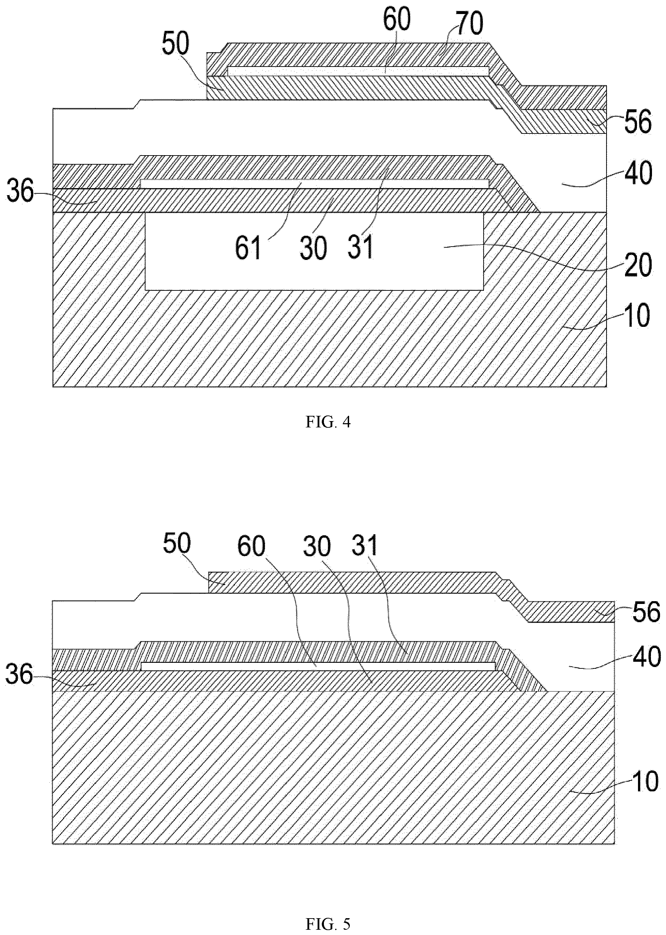

Fig. 4 is a schematic sectional view along A1-A2 in Fig. 1 according to an exemplary embodiment of the present disclosure, in which a top electrode and a bottom electrode are both provided with gap layers. As shown in Fig. 4, the top and bottom electrodes of the resonator both have double-layer structures, an air gap 61 is formed between the bottom electrode 30 and the bottom electrode 31, and an air gap 60 is formed between the top electrode 50 and the top electrode 70. In the embodiment shown in Fig. 4, the top electrode 70 and the bottom electrode 30 are additional electrodes.

Fig. 5 is a schematic sectional view along A1-A2 in Fig. 1 according to an exemplary embodiment of the present disclosure, in which a bottom electrode is provided with a gap layer, and the gap layer is used as an acoustic lens structure. As shown in Fig. 5, when the bottom electrode of the resonator has an air gap structure 60, a cavity structure originally located in the substrate can be replaced by the air gap to function as an acoustic reflection layer. This structure not only simplifies the process, but also significantly increases a contact area between the bottom electrode 30 and the substrate 10, and improves the heat diffusion efficiency of the substrate, thereby improving the power capacity of the resonator. It is apparent from the above that the top electrode of the resonator in Fig. 5 may employ a structure containing an air gap. In the embodiment shown in Fig. 5, the bottom electrode 30 corresponds to an additional electrode or additional electrode layer.

In the present disclosure, the gap layer is provided in the top electrode and/or the bottom electrode of the bulk acoustic wave resonator. The air gap of the electrode can effectively reflect acoustic waves, thereby greatly reducing the energy of the acoustic waves entering the additional electrode on a side away from a piezoelectric film (or the piezoelectric layer), thus effectively suppressing or eliminating negative effects of the additional electrode caused by participating in acoustic vibration. In addition, two layers (a plurality of layers) of electrodes enclosing the air gap may form a parallel circuit structure, which can effectively reduce the electrical loss of the resonator and improve the Q value of the resonator, especially the Q value at a series resonance point and its nearby frequencies.

Therefore, the additional electrode is acoustically decoupled from the resonant cavity of the resonator due to the presence of the air gap since most of acoustic waves are reflected back to the resonant cavity at the air gap and do not enter the additional electrode. Other key parameters (such as the resonant frequency and the electromechanical coupling coefficient) other than the Q value of the resonator are not affected by the additional electrode and parameter changes.

Compared with a structure in which the air gap is located between the piezoelectric layer and the electrode, the present disclosure has the advantages that since parasitic series capacitance caused by the air gap is avoided, the electromechanical coupling coefficient kt² of the resonator will not deteriorate. Compared with a structure in which a temperature compensation interlayer (e.g., silicon dioxide) is located between two layers of electrodes, the air gap or vacuum gap of the present disclosure maintains the resonant frequency of the resonator unchanged. In this way, other key parameters (such as, the Q value and the electromechanical coupling coefficient) will not deteriorate, and the Q value at the series resonance point and its nearby frequencies is increased on the contrary.

In the present disclosure, the electrode provided with the gap layer is a gap electrode. In the illustrated embodiments, the gap electrode has a double-layer structure formed by an upper layer and a lower layer, and is provided with only one gap layer. However, the present disclosure is not limited to thereto, for example, the gap electrode may have a multi-layer stacked electrode structure.

In the present disclosure, when the acoustic lens structure is provided in the substrate and no gap layer is provided in the bottom electrode, an effective region of the resonator is an overlapping region of the top electrode, the piezoelectric layer, the bottom electrode, and the acoustic lens in the thickness direction of the resonator. At this time, in a top view of the resonator, the gap layer may overlap the effective region, and further, the gap layer extends across at least 50% of an area of the effective region in a lateral direction.

In the present disclosure, when the gap layer is provided in the bottom electrode, the effective region of the resonator is an overlapping region of the top electrode, the bottom electrode, the piezoelectric layer, and the gap layer of the bottom electrode in the thickness direction of the resonator. As shown in Figs. 3A, 3B and 4, in the top view of the resonator, the gap layer fully covers the cavity 20. The full coverage herein means that the gap layer extends completely across the edges of the cavity 20 at all angles in the lateral direction. If the gap layer is provided in the bottom electrode, the gap layer may be provided in the top electrode or not at the same time.

In the present disclosure, a mentioned numerical range may not only be endpoint values, but may also be a mean value of the endpoint values or other values, which all fall within the scope of the present disclosure.

As can be appreciated by those skilled in the art, the bulk acoustic wave resonator according to the present disclosure may be used to form a filter.

Based on the above description, the present disclosure provides the following technical solutions.
1. A bulk acoustic wave resonator includes:
   a substrate;
   an acoustic mirror;
   a bottom electrode;
   a top electrode, and
   a piezoelectric layer provided between the bottom electrode and the top electrode,
   wherein the bottom electrode and/or the top electrode is a gap electrode, the gap electrode has at least one gap layer, and in a thickness direction of the gap electrode, the at least one gap layer is spaced apart from a top surface and a bottom surface of the gap electrode.
2. The resonator according to 1, wherein
   the gap electrode has a gap layer.
3. The resonator according to 1, wherein
   the at least one gap layer is an air gap layer or a vacuum gap layer.
4. The resonator according to 1, wherein
   the at least one gap layer has a thickness in a range of 50 Å to 10000 Å.
5. The resonator according to 4, wherein
   the thickness of the at least one gap layer is in a range of 100 Å to 5000 Å.
6. The resonator according to any one of 1-5, wherein
   the gap electrode has a plurality of electrode layers that is stacked on each other in the thickness direction of the resonator and is connected in parallel to each other, and the at least one gap layer is provided between corresponding ones of the plurality of electrode layers.
7. The resonator according to 6, wherein
   in a section of the resonator parallel to the thickness direction of the resonator, two electrode layers of the plurality of electrode layers that are located on upper and lower sides of a corresponding gap layer of the at least one gap layer have ends on lateral edges of the corresponding gap layer, which are electrically connected to each other.
8. The resonator according to 7, wherein
   in a section of the resonator parallel to the thickness direction of the resonator, the two electrode layers have pin ends electrically connected to each other and non-pin ends electrically connected to each other.
9. The resonator according to 6, wherein
   the resonator further includes a gap passivation layer having a planar shape same as that of the at least one gap layer, the gap passivation layer is stacked with the at least one gap layer, the gap passivation layer is arranged on a top surface of a corresponding one of the plurality of electrode layers, and the at least one gap layer covers a top surface of the gap passivation layer.
10. The resonator according to 6, wherein
   the gap electrode has two electrode layers and one gap layer, and the gap layer is arranged between the two electrode layers.
11. The resonator according to 1, wherein
   the bottom electrode is a gap electrode, and the at least one gap layer forms the acoustic lens.
12. The resonator according to 11, wherein
   the top electrode, the bottom electrode, the piezoelectric layer and the at least one gap layer overlap with each other in the thickness direction of the resonator to form an overlapping region, and the overlapping region forms an effective region of the resonator; and
   the resonator further includes an acoustic cavity provided in the substrate, and in a top view of the resonator, the at least one gap layer fully covers the acoustic cavity.
13. The resonator according to 1, wherein
   the top electrode is a gap electrode; and
   the top electrode, the piezoelectric layer, the bottom electrode and the acoustic lens overlap with each other in the thickness direction of the resonator to form an overlapping region, and the overlapping region forms an effective region of the resonator.
14. A filter includes the bulk acoustic wave resonator according to any one of 1-13.

The embodiments of the present disclosure also relate to an electronic device including the above resonator or the above filter.

Although the embodiments of the present disclosure have been shown and described, it will be understood by those skilled in the art that changes can be made to these embodiments without departing from the principles and spirit of the present disclosure, and the scope of the present disclosure is determined by the appended claims and their equivalents.

## Claims

1. A bulk acoustic wave resonator, comprising:
a substrate;
an acoustic lens;
a bottom electrode;
a top electrode, and
a piezoelectric layer provided between the bottom electrode and the top electrode,
wherein the bottom electrode and/or the top electrode is a gap electrode, the gap electrode has at least one gap layer, and in a thickness direction of the gap electrode, the at least one gap layer is spaced apart from a top surface and a bottom surface of the gap electrode.

2. The resonator according to claim 1, wherein the gap electrode has a gap layer.

3. The resonator according to claim 1, wherein the at least one gap layer is an air gap layer or a vacuum gap layer.

4. The resonator according to claim 1, wherein the at least one gap layer has a thickness in a range of 50 Å to 10000 Å.

5. The resonator according to claim 4, wherein the thickness of the at least one gap layer is in a range of 100 Å to 5000 Å.

6. The resonator according to any one of claims 1-5, wherein the gap electrode has a plurality of electrode layers that is stacked on each other in the thickness direction of the resonator and is connected in parallel to each other, and the at least one gap layer is provided between corresponding ones of the plurality of electrode layers.

7. The resonator according to claim 6, wherein in a section of the resonator parallel to the thickness direction of the resonator, two electrode layers of the plurality of electrode layers that are located on upper and lower sides of a corresponding gap layer of the at least one gap layer have ends on lateral edges of the corresponding gap layer, and the ends of the two electrode layers are electrically connected to each other.

8. The resonator according to claim 7, wherein in a section of the resonator parallel to the thickness direction of the resonator, the two electrode layers have pin ends electrically connected to each other and non-pin ends electrically connected to each other.

9. The resonator according to claim 6, further comprising:
a gap passivation layer provided on a top surface of a corresponding one of the plurality of electrode layers, the gap passivation layer having a planar shape same as a planar shape of the at least one gap layer, the gap passivation layer being stacked with the at least one gap layer, and the at least one gap layer covering a top surface of the gap passivation layer.

10. The resonator according to claim 6, wherein the gap electrode has two electrode layers and one gap layer, and the gap layer is arranged between the two electrode layers.

11. The resonator according to claim 1, wherein the bottom electrode is a gap electrode, and the at least one gap layer forms the acoustic lens.

12. The resonator according to claim 11, further comprising:
an acoustic cavity provided in the substrate, the at least one gap layer fully covering the acoustic cavity in a top view of the resonator,
wherein the top electrode, the bottom electrode, the piezoelectric layer and the at least one gap layer overlap with each other in the thickness direction of the resonator to form an overlapping region, and the overlapping region forms an effective region of the resonator.

13. The resonator according to claim 1, wherein the top electrode is a gap electrode; and the top electrode, the piezoelectric layer, the bottom electrode and the acoustic lens overlap with each other in the thickness direction of the resonator to form an overlapping region, and the overlapping region forms an effective region of the resonator.

14. A filter, comprising the bulk acoustic wave resonator according to any one of claims 1-13.

15. An electronic device, comprising the filter according to claim 14 or the resonator according to any one of claims 1-13.
